Europäisches Patentamt

European Patent Office

Office européen des brevets

(11) Numéro de publication : **0 407 263 B1**

(12) **FASCICULE DE BREVET EUROPEEN**

(45) Date de publication du fascicule du brevet :
**30.09.92 Bulletin 92/40**

(21) Numéro de dépôt : **90401823.1**

(22) Date de dépôt : **26.06.90**

(51) Int. Cl.⁵ : **H03J 5/24,** H03D 7/16,
H04N 7/20

(54) **Système de réception de signaux t.v. retransmis par satellites.**

(30) Priorité : **04.07.89 FR 8908967**

(43) Date de publication de la demande :
**09.01.91 Bulletin 91/02**

(45) Mention de la délivrance du brevet :
**30.09.92 Bulletin 92/40**

(84) Etats contractants désignés :
**AT BE CH DE ES GB GR IT LI LU NL SE**

(56) Documents cités :
**EP-A- 0 276 144**
**DE-A- 3 226 980**
**US-A- 4 608 710**

(73) Titulaire : **THOMSON COMPOSANTS MICROONDES**
**51, Esplanade du Général de Gaulle**
**F-92800 Puteaux (FR)**
Titulaire : **THOMSON-LGT LABORATOIRE GENERAL DES TELECOMMUNICATIONS**
**1, rue de l'Hautil**
**F-78700 Conflans-Sainte Honorine (FR)**

(72) Inventeur : **Mutzig, Jean-Paul**
**Thomson-CSF, SCPI, Cédex 67**
**F-92045 Paris la Défense (FR)**
Inventeur : **Cluniat, Claude**
**Thomson-CSF, SCPI, Cédex 67**
**F-92045 Paris la Défense (FR)**
Inventeur : **Bert, Alain**
**Thomson-CSF, SCPI, Cédex 67**
**F-92045 Paris la Défense (FR)**

(74) Mandataire : **Taboureau, James et al**
**THOMSON-CSF SCPI 51, Esplanade du Général de Gaulle**
**F-92045 Paris La Défense - Cédex 67 (FR)**

## Description

La présente invention concerne une tête hyperfréquence à démodulation directe, permettant la réception des signaux de télévision ou télécommunication retransmis par satellite terrestre. Cette tête, unique, et située à proximité de l'antenne de réception parabolique, permet de démoduler simultanément plusieurs canaux de transmission parmi tous les canaux disponibles sur plusieurs satellites. Elle se raccorde sur le multiplexeur des antennes existantes UHF et VHF de réception hertzienne, et utilise de ce fait le câble de descente UHF-VHF existant vers le récépteur de télévision, ou le matériel de télécommunication.

L'une des difficultés liées à la réception de signaux retransmis par satellites est causée par la multiplicité des formes de signaux retransmis selon :
- la position orbitale des satellites, situés, pour la France, entre 20° Est et 40° Ouest,
- leur fréquence de bande porteuse, comprise entre 11 GHz et 12,8 GHz
- le type de polarisation de l'onde transmise par le satellite, qui est polarisée linéairement verticale ou horizontale, ou circulairement gauche ou droite.

Cette dernière caractéristique concerne la technologie et le type de source d'illumination de l'antenne, et sort du domaine de l'invention, mais il demeure que l'électronique de réception doit pouvoir être compatible avec toute la bande couverte soit, actuellement, une largeur de bande de l'ordre de 1,8 GHz.

Selon l'art connu, la structure d'un système de réception TV par satellite comprend deux sous-ensembles : une unité externe, située par exemple sur le toit de l'immeuble, et une unité interne, qui se présente souvent sous forme d'un coffret glissé sous le récepteur.

La fonction de l'unité externe est :
- de capter l'énergie transmise par le satellite à l'aide d'une antenne,
- d'amplifier le signal reçu (environ -80 à -90 dBm par canal),
- de transposer le signal reçu (bandes 10.95 à 11,7, 11.7 à 12.5 12.5 à 12.75 GHz), dans une bande à fréquence intermédiaire de 950 à 1700 MHz.

La fonction de l'unité interne est :
- de sélectionner le canal à recevoir à l'aide d'un synthétiseur et d'un convertisseur de fréquence. Un filtre à onde de surface habituellement à 480 ou 612 MHz permet d'éliminer les canaux adjacents.
- de démoduler le signal modulé en fréquence à l'aide :
- soit d'un discriminateur de fréquence standard,
- soit d'une boucle à verrouillage de phase permettant d'augmenter le seuil de sensibilité du démodulateur (gain de 2 à 3 dB environ).

L'avantage essentiel de cette structure est de minimiser la complexité de l'unité externe.

Dans le cas de la réception simultanée de plusieurs satellites, chaque satellite nécessite une antenne de réception spécifique. Il faut donc prévoir entre les unités externes (antennes et convertisseurs) et les unités internes (démodulateurs satellite) autant de liaisons descendantes que de satellites. Lorsque deux polarisations différentes sont exploitées simultanément sur un même satellite, il faut prévoir une commutation des fréquences intermédiaires, ou deux descentes d'antenne par satellite.

Dans le cas de la réception séquentielle de plusieurs satellites, il est possible de simplifier le problème grâce à un boîtier de commutation qui permet de choisir "n" sorties parmi "p" possibilités et de les aiguiller vers les utilisateurs intéressés. Le cas limite est celui d'un seul utilisateur qui souhaite recevoir séquentiellement une polarisation sur un satellite à la fois. Il faut donc dans ce cas une antenne multisatellite pointée électriquement sur le satellite choisi et qui possède le nombre de types de sources hyperfréquences et de convertisseurs compatibles.

Mais de plus, les téléviseurs récents possèdent une voie image en inclusion vidéo fréquence qui permet d'observer simultanément ce qui se passe sur un programme principal et sur un autre programme en vue de son enregistrement.

Il faut pouvoir disposer simultanément
- d'un programme principal
- d'un programme quelconque en insertion surimposée
- d'un programme pour l'enregistrement
ce qui suppose, au moins, trois voies indépendantes de réception satellite et de démodulation. Dans ce cas, il faut recevoir simultanément tous les signaux. Il y a impossibilité à réaliser ces fonctions avec une antenne unique monofaisceau à pointage motorisé.

A titre d'exemple, pour recevoir les principaux satellites disponibles en France à fin 1989, il faudrait disposer de :
- 6 antennes de dimensions adaptées aux différentes puissances des satellites,
- de polarisation soit linéaire (H ou V), soit circulaire (C+ ou C-),
- recevant des signaux dans des bandes différentes,
ce qui oblige à utiliser trois types de têtes hyperfréquences, couvrant respectivement les sous-bandes de 10,95 à 11,7 GHz, de 11,7 à 12,5 GHz et de 12,5 à 12,75 GHz.

Il faut 10 descentes d'antennes ou une matrice de commutateurs qui permet de choisir 3 programmes parmi 10.

Il faut aussi au moins trois tuners satellites, polyvalents au plan des excursions de fréquence et au plan des sous-porteuses son.

On voit donc que la réception simultanée de faisceaux terrestres en UHF-VHF et de faisceaux retransmis par satellites entraîne une installation assez complexe, et coûteuse.

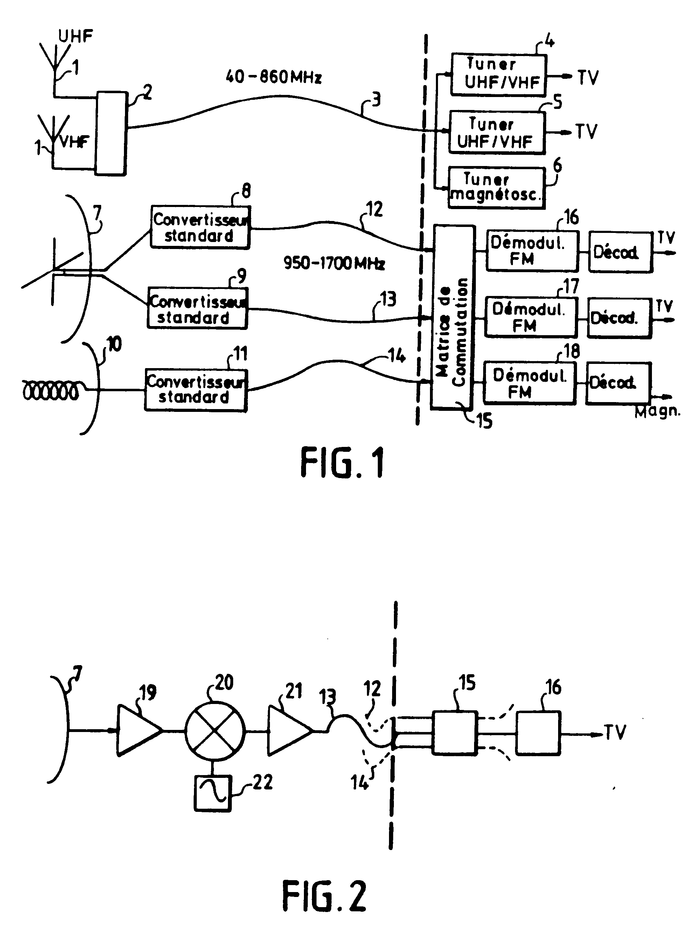

La figure 1 en donne un exemple.

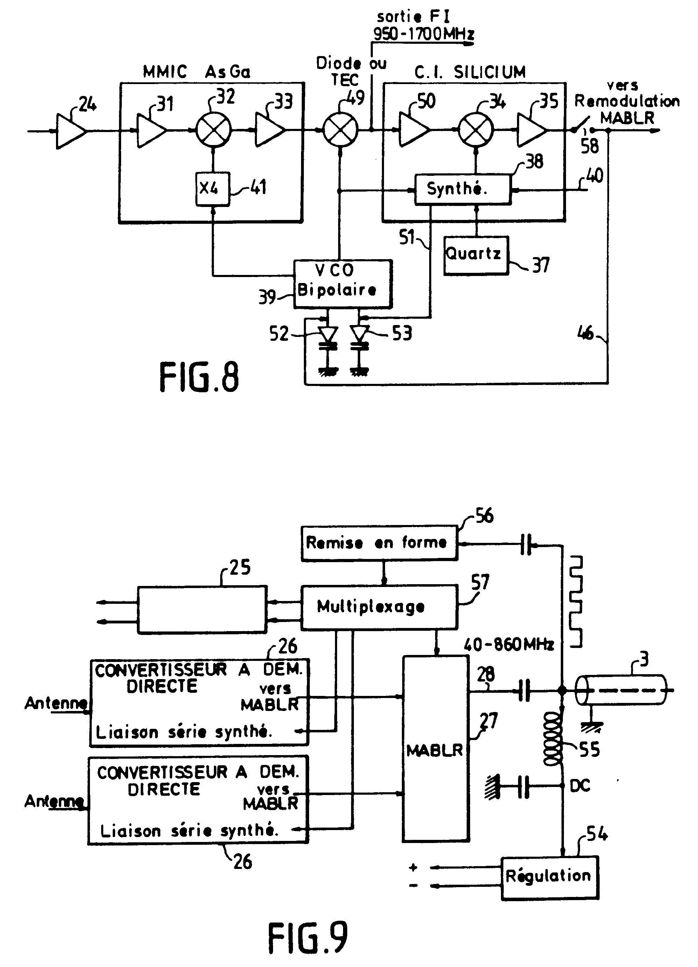

Sur cette figure, comme sur toutes les autres sauf les figures 8 et 9, le trait pointillé vertical sépare l'unité externe, à gauche de la figure, de l'unité interne, à droite.

Selon l'art connu, un ensemble de réception hertzienne et par satellites comprend deux systèmes différents, séparés, qui ne se rejoignent qu'au niveau du récepteur TV ou du matériel de télécommunications.

Le circuit de réception hertzienne "terrestre" comprend une antenne 1, généralement combinée pour les signaux VHF (40 - 250 MHz) et UHF (350-860 MHz), un multiplexeur 2, et un câble coaxial blindé 3, qui transporte un signal modulé en amplitude, dans une bande comprise entre 40 et 860 MHz. Ce câble descend jusqu'au matériel de réception, dans lequel il alimente, à titre d'exemple, un tuner 4 qui fournit une image principale, un tuner 5 qui fournit une image incrustée dans la précédente, et un tuner 6 d'enregistrement par magnétoscope.

Si une telle installation, classique, doit être modifiée pour recevoir plusieurs canaux retransmis par plusieurs satellites, il faut lui adjoindre, à titre d'exemple :

– une antenne parabolique 7, adaptée aux signaux polarisés horizontalement et verticalement, et deux convertisseurs 8 et 9, un pour chaque type de polarisation,

– une antenne parabolique 10, adaptée aux signaux polarisés circulairement, et un convertisseur 11.

Pour chacun des convertisseurs 8,9,11, un câble coaxial spécial 12,13 ou 14 transmet un signal modulé en FM entre 950 et 1700 MHz, vers l'unité interne composée d'une matrice de commutation 15 et d'autant de démodulateurs FM 16,17,18 que l'on veut démoduler simultanément de canaux transmis par satellite.

A titre d'exemple, si l'antenne 7 reçoit 16 canaux et l'antenne 10 reçoit 4 canaux, il faut 3 câbles 12,13,14 et 3 démodulateurs 16,17,18 pour démoduler simultanément 3 canaux parmi 20.

L'inconvénient de ce système est évident : il nécessite un grand nombre de convertisseurs 8,9,11, dont chacun n'a pas une bande passante suffisante pour couvrir la largeur de bande couverte par tous les satellites, et il nécessite un grand nombre de câbles de liaison 12,13,14.

En ce qui concerne les câbles de liaison, il faut donc installer des câbles nouveaux, en plus du câble 3, qui transportent des signaux modulés en FM à 0.95 - 1,75 GHz. De ce fait, les contraintes d'installation conduisent à des coûts élevés.

En ce qui concerne les convertisseurs, la figure 2 montre pourquoi leur largeur de bande passante est insuffisante. Les convertisseurs actuellement utilisés comprennent un amplificateur à faible bruit 19, qui reçoit le signal provenant de l'antenne parabolique 7, par exemple, puis un mélangeur 20 et un amplificateur de sortie 21. Le mélangeur 20 reçoit également le signal issu d'un oscillateur local 22, qui, pour des raisons pratiques et économiques, est généralement à résonateur diélectrique, ou DRO (Dielectric Resonator Oscillator).

Pour que ce convertisseur soit multibande, et adapté à la réception de plusieurs satellites, il lui faut plusieurs oscillateurs locaux 22 monofréquence ou commutables. Actuellement, la solution la plus courante réside en un oscillateur local à 2 fréquences commutables, ce qui ne permet de recevoir que 2 sous-bandes par voie de convertisseur.

Cette solution est insuffisante au regard du nombre de satellites en orbite, et à venir, et du nombre de canaux disponibles pour la retransmission TV et les télécommunications.

L'invention propose une solution à la multiplication des convertisseurs, en unité externe, et des câbles de liaison vers l'unité interne, en adaptant une tête hyperfréquence, sise en unité externe, intégrée à l'antenne par exemple. Cette tête de réception comprend un convertisseur multibande, à fréquence programmée par commande depuis l'unité interne : une seule tête de réception peut traiter de 20 à 40 canaux. Mais de plus, les signaux reçus sont démodulés et traités sur place par la tête hyperfréquence qui délivre des signaux remodulés en amplitude, ce qui permet de les adresser au multiplexeur des antennes VHF-UHF réception herztienne terrestre, et d'utiliser l'unique câble de liaison existant, à 40-860 MHz.

La tête hyperfréquence selon l'invention se présente donc comme un dispositif intercalé entre les antennes paraboliques et le multiplexeur des antennes hertziennes et qui ne nécessite pas d'autre modification de l'installation existante, et en particulier ne nécessite plus la pose de nombreux câbles spéciaux pour signaux modulés en FM à 0,95-1,70 GHz.

De façon plus précise, l'invention consiste en un système de réception de signaux TV retransmis par satellites, destiné à la transmission d'au moins un canal parmi une pluralité de canaux depuis au moins une antenne, en unité externe, vers au moins un récepteur en unité interne, ce système étant caractérisé en ce qu'il comprend, en unité externe, une tête hyperfréquence qui comporte au moins :

– un circuit de démodulation hyperfréquence qui sélectionne le canal choisi et le démodule, ce circuit étant piloté par une unique source hyperfréquence programmée depuis l'unité interne

– un circuit de remodulation en amplitude à bande latérale résiduelle (MABLR), qui délivre des signaux modulés en amplitude dans la bande 40-860 MHz, de même type que les signaux VHF/UHF reçus par les antennes de transmission "terrestre".

L'invention sera mieux comprise par la description plus détaillée qui suit maintenant de deux exemples, illustrés par les figures jointes en annexe, qui représentent :

– fig. 1 et 2 : système de réception selon l'art connu, précédemment explicitées,

– fig. 3 : système de réception au moyen d'une tête hyperfréquence selon l'invention, permettant de démoduler au moins deux canaux satellites parmi ceux reçus par les antennes,

– fig. 4 : généralisation de la tête hyperfréquence de la figure 3 à la réception de N canaux parmi M.

– fig. 5,6 et 7 : schémas en diagrammes de bloc des circuits de réception de la tête hyperfréquence selon l'invention, à différents états d'intégration,

– fig. 8 : schéma électrique du convertisseur large bande et du module RF/FI, plus le synthétiseur qui permet la commande en fréquence du convertisseur, selon l'invention.

– fig. 9 : schéma d'ensemble de l'interface entre l'unité interne et l'unité externe, selon l'invention.

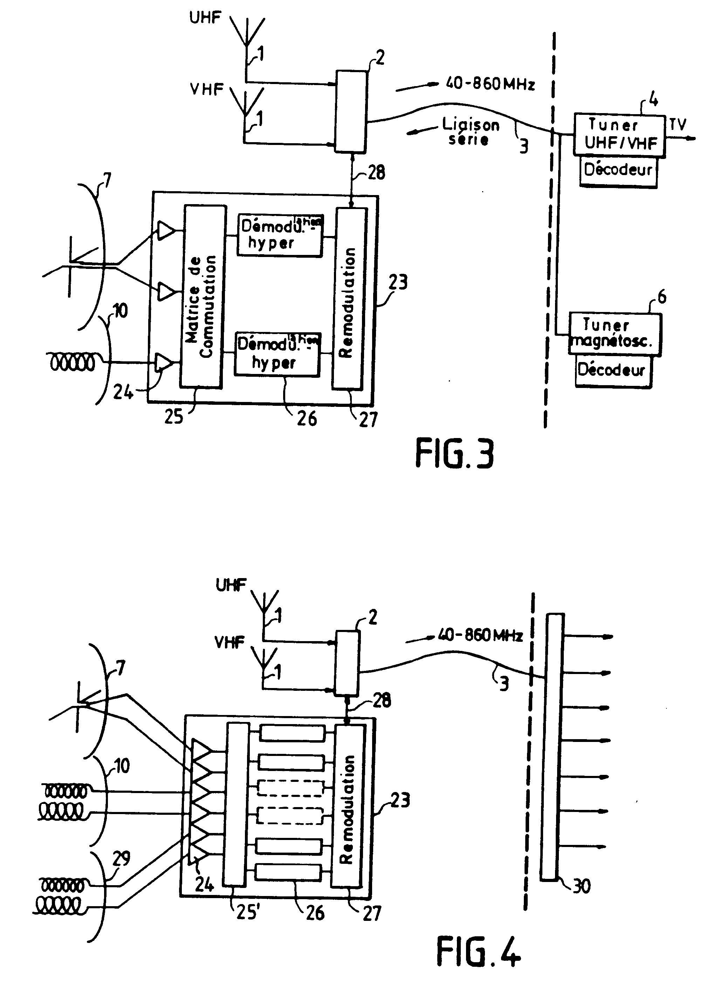

La figure 3 représente le système de réception de signaux retransmis par satellites, selon l'invention. L'unité externe de réception de signaux terrestres comportant les antennes VHF/UHF 1, le multiplexeur 2 et le câble de liaison 3 vers l'unité interne est supposée exister déjà, parce que c'est le cas le plus courant. S'il n'en est pas ainsi, il suffit de poser un câble de liaison 3 classique, adapté aux signaux 40-860 MHz en modulation d'amplitude.

Ce système de réception de signaux satellites repose sur une tête hyperfréquence 23, intercalée entre la ou les antennes paraboliques 7 et 10, et le multiplexeur 2 de l'installation existante. Le nombre et le type des antennes paraboliques ne limite pas la portée de l'invention, et, s'il n'y a pas de multiplexeur 2, le câble de liaison 3 est connecté directement sur la tête hyperfréquence 23, puisque l'un de ses objectifs est de traiter les signaux satellites pour les rendre compatibles avec les signaux terrestres, et passer par le même câble.

La structure de la tête hyperfréquence 23, qui sera détaillée plus loin comprend :

– une série d'amplificateurs 24, à faible bruit, dont chacun reçoit sur son entrée le signal provenant d'une antenne parabolique, ou d'un élément d'antenne, selon la polarisation du signal,

– une matrice de commutation permettant de sélectionner le ou les canaux choisis parmi ceux transmis par le ou les satellites ; cette matrice permet le choix du programme de plusieurs canaux transmis simultanément,

– au moins deux démodulateurs hyperfréquences 26,

– un circuit de remodulation 27, qui retransforme les signaux modulés en FM en bande de base, 0-6 MHz par exemple, issus des démodulateurs 26, en signaux modulés en amplitude dans la bande 40-860 MHz

– une liaison descendante 40-860 MHz, vers l'unité interne

– une liaison montante utilisant le même support physique 3 + 28, permettant de transmettre les informations numériques nécessaires à la sélection du ou des satellites, et des canaux à démoduler. Elle permet aussi de décider du plan de fréquence de la remodulation, qui est fonctions des canaux hertziens déjà reçus localement.

L'invention couvre également le cas où il n'y a qu'un seul démodulateur hyperfréquence 26, mais elle manque d'intérêt parce que trop restreinte, compte tenu du nombre de canaux diffusés par des satellites et du nombre d'appareils de réception qui peuvent être desservis simultanément, en unité interne, par la tête hyperfréquence selon l'invention.

Bien au contraire, la figure 4 montre l'intérêt de la tête hyperfréquence selon l'invention pour exploiter simultanément un grand nombre de canaux transmis par satellites. Le nombre d'amplificateurs 24 est adapté au nombre et aux types d'antennes paraboliques 7,10,29, et au nombre de canaux correspondants.

Mais dans ce cas, la matrice de commutation 25 de la figure 4 est remplacée par un répartiteur de puissance 25' qui transmet tous les canaux à une pluralité de démodulateurs hyperfréquences 26. Ceci constitue une solution au service collectif d'un immeuble, grâce auquel un grand nombre d'utilisateurs peuvent recevoir chacun un canal différent, puisque tous les canaux sont démodulés simultanément. Ce service est connu sous le sigle SMATV, pour Satellite Master Antenna TV.

Le nombre de démodulateurs 26 peut être supérieur au nombre de canaux reçus. Si par exemple :

– l'antenne 7 reçoit 8 canaux polarisés verticalement et 8 canaux polarisés horizontalement,

– l'antenne 10 reçoit 4 canaux polarisés circulairement à droite,

– l'antenne 29 reçoit dans les mêmes conditions que l'antenne 10, mais d'un autre satellite,

il faut 6 amplificateurs 24, et on peut installer jusque 32 démodulateurs 26 dans la tête hyperfréquence.

Il est bon de prévoir une redondance, sous forme d'une voie en réserve qui, si l'une quelconque des voies principales tombe en panne, peut la remplacer automatiquement.

Les signaux issus des démodulateurs hyperfréquences 26 sont, comme dans le cas précédent, adressés à un circuit de remodulation 27, dit MABLR ou à modulation d'amplitude à bande latérale résiduelle.

Les signaux de sortie de la tête empruntent tous l'unique câble de liaison 3, et sont adressés par le répartiteur 30, dans l'unité interne, aux divers appareils de réception, soit télévision doit télécommunications, dont chacun décode les informations correspondant à un canal. A titre d'exemple, la tête hyperfréquence selon l'invention permet d'exploiter simultanément jusque 20 à 40 canaux, en réception collective pour un immeuble ou un centre de télécommunications.

Le coeur du système réside dans le démodulateur hyperfréquence, dont la fonction est de sélectionner un canal et de démoduler le signal hyperfréquence modulé en fréquence, en respectant les caractéristiques exigées par les normes : réjection des canaux adjacents, linéarité...

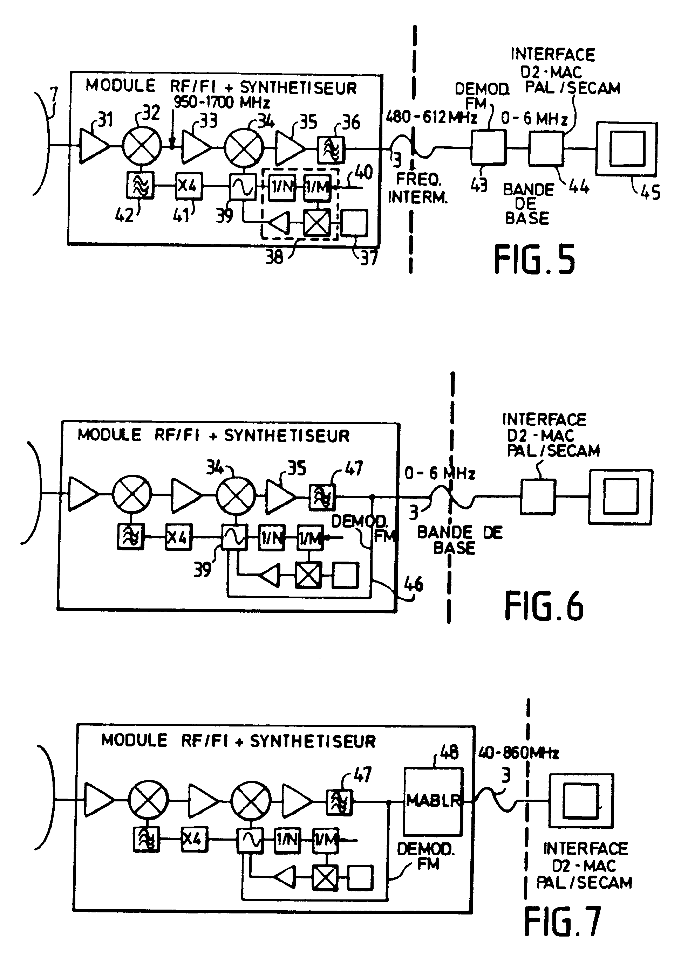

De façon à faciliter la compréhension de la solution proposée, ce démodulateur hyperfréquence est présenté à différentes étapes d'intégration dans les figures 5, 6, et 7.

En figure 5, l'unité externe comprend un convertisseur faible bruit multibande et un module RF/FI ainsi qu'un synthétiseur, tous représentés sous forme de diagramme de blocs. La matrice de commutation n'est pas représentée, par simplification.

Le convertisseur comprend un amplificateur d'entrée 31, à faible bruit, qui reçoit les signaux de l'antenne 7, un mélangeur 32 et un amplificateur de sortie 33. Il est piloté par un oscillateur multibande sur lequel on reviendra ultérieurement. Ce convertisseur permet de transposer toute la bande de fréquence d'un satellite dans une gamme de fréquence 0,95 à 1,70 GHz.

Il est suivi par un module RF/FI, permettant de transposer le canal sélectionné à une fréquence fixe intermédiaire (FI), 480 ou 612 MHz selon les constructeurs.

Ce module RF/FI comprend un mélangeur 34, un amplificateur 35 et un filtre de sortie 36, qui fonctionne donc à fréquence intermédiaire.

Le convertisseur et le module RF/FI sont tous deux pilotés à partir d'un quartz 37 qui, à travers un synthétiseur 38, contrôle un oscillateur 39. Le synthétiseur est un ensemble connu et disponible sur le marché : commandé sur son entrée 40 par des informations numériques transmises par le câble de liaison 3, il permet de sélectionner un canal, ou N canaux parmi M, en choisissant une fréquence adéquate. L'oscillateur 39 pilote directement le mélangeur 34, du module RF/FI, par exemple à 2,3 GHz.

Mais une sortie de ce même oscillateur 39 est adressée sur un multiplicateur 41, qui pilote le mélangeur 32 du convertisseur à travers un filtre 42. Le convertisseur est donc multibande, puisqu'il est piloté par une fréquence choisie à travers le synthétiseur 38.

Dans le cas présent, un multiplicateur par 4 a été choisi dans un but de simplification : il existe sur le marché des synthétiseurs à 2,3 GHz, qui correspondent bien au mélangeur 34 du module RF/FI et qui, multipliés par 4 = 9,2 GHz, correspondent bien à la bande de fréquences reçues par le convertisseur : 11 à 13 GHz.

Le démodulateur hyperfréquence de la figure 5 transmet sur le câble de liaison 3 un signal à fréquence intermédiaire, 480 ou 612 MHz, qui, dans l'unité interne est démodulé par le démodulateur FM 43, qui fournit un signal en bande de base, 0-6 MHz par exemple. Celui-ci est traité par un interface 44, selon que les signaux sont en Sécam, en PAL ou en D2 Mac par exemple, avant d'être transformé dans le récepteur TV 45, ou le matériel de télécommunications. Cependant, dans le cas d'une réception simultanée de plusieurs bandes de réception satellite, il faut toujours plusieurs convertisseurs et plusieurs liaisons entre unités externe et interne.

Parmi différents types possibles de démodulateurs FM, on sait qu'un système rebouclé sur lui-même oscillateur -mélangeur-amplificateur fournit un démodulateur par boucle de phase d'excellentes spécifications. Or le module RF/FI de la figure 5 comporte un oscillateur 39, un mélangeur 34 et un amplificateur 35 : il suffit de les reboucler par une liaison 46, comme représenté en figure 6, pour intégrer le démodulateur FM 43 de la figure 5 dans la tête hyperfréquence. Cette configuration est plus intéressante parce que plus simple et plus intégrée - tout le système est dans l'unité externe - . Cependant, le filtre de sortie 47 fonctionne en bande de base 0-6 MHz : il est donc différent du filtre 36 de la figure 5 qui fonctionnait en fréquence intermédiaire, mais surtout les signaux transmis à 0-6 MHz sont sensibles aux parasites dûs à l'environnement du câble de liaison 3. Et il faut toujours plusieurs liaisons entre unités externe et interne en case de réception simultanée.

C'est donc un avantage de l'invention que de remoduler le signal, comme représenté en figure 7. Le modulateur 48 reçoit le signal en bande de base. 0-6 MHz, issu du filtre 47, et le module en amplitude à bande latérale résiduelle (MABLR) : il envoie dans le câble de liaison 3 des signaux à 40-860 MHz qui sont insensibles aux parasites. Ce qui permet au système d'être compatible avec les liaisons standards existantes puisque la tête hyperfréquence selon l'invention fournit des signaux modulés en amplitude dans la bande 40-860 MHz, comme les antennes VHF-UHF conventionnelles. De plus, dans le cas d'une réception simultanée une seule liaison suffit pour transmettre plusieurs programmes, par pas de 8 MHz par exemple.

La figure 8 représente le schéma électrique du convertisseur à démodulation directe. De même que sur les figures 5 à 7, la matrice de commutation 25 n'est pas représentée, par simplification.

Il est composé de :

– un étage d'entrée 24, amplificateur à transistor à hétérojonction en GaAs (Tegfets) à faible bruit,
– un convertisseur de fréquence, compatible avec la technologie du GaAs. Sur une puce de GaAs, il comprend un amplificateur 31, qui joue également le rôle du filtre 42 de la figure 5, un mélangeur 32 et un amplificateur de sortie 33. Le multiplicateur 41 constitue l'oscillateur local, mais, comme cela a été dit précédemment, il n'est là que parce qu'on dispose dans le commerce de synthétiseurs à 2,3 GHz par exemple. Bien entendu appartient au domaine de l'invention le cas où le multiplicateur est remplacé par un oscillateur local voisin de 10 GHz, piloté par le synthétiseur 38.
– une fonction de mélange 49, qui est une diode ou un transistor à effet de champ, transmet au module RF/FI le signal issu du convertisseur de fréquence,
– un circuit sur silicium, comprenant l'amplificateur 50, le comparateur de phase 34 et l'amplificateur de boucle 35, et le synthétiseur 38, qui est programmé par des informations numériques transmises par la liaison série montante.
– un pilote à quartz 37, extérieur au circuit sur silicium, sert de référence de fréquence au synthétiseur 38 qui, par une liaison 51, contrôle un oscillateur VCO bipolaire 39, comportant deux diodes varactors 52 et 53. Les sorties de cet oscillateur 39, à 2,3 GHz par exemple, sont adressées au multiplicateur 41, au mélangeur 49 et au synthétiseur 38, en boucle de contre-réaction.

Une liaison 46, qui réunit la sortie du module RF/FI à l'une des diodes varactors 52, forme le démodulateur FM qui a été décrit précédemment. A partir de cette même sortie du module RF/FI, les signaux sont adressés également au circuit 48 de remodulation MABLR. Ce circuit n'est ni représenté, ni détaillé, car il est en soi connu : il fournit un signal modulé en amplitude, à bande latérale résiduelle, dans la bande 40-860MHz. La remodulation MABLR permet la réception simultanée de plusieurs canaux satellites sur une unique liaison externe-interne.

La figure 9 présente le synoptique de l'interface entre unités externes et unités internes : cette interface transmet les canaux remodulés MABLR, apporte l'énergie pour alimenter l'unité externe, et véhicule les informations numériques pour configurer une pluralité de modulateurs VHF/UHF à MABLR choisis pour les canaux sélectionnés.

Cette figure est simplifiée du côté des antennes et de la matrice de commutation 25. Au moins un convertisseur à démodulation directe 26 délivre ses signaux vers un remodulateur MABLR 27, qui utilise un câble standard 3 pour transmettre vers l'unité interne des signaux 40-860 MHz.

Mais une alimentation régulée 54, injecte un courant continu, filtré par les éléments LC 55, sur ce même câble 3 : les informations numériques nécessaires à la programmation de la tête hyperfréquence selon l'invention, provenant de l'unité interne, sont adressées à un circuit de remise en forme 56 puis à un circuit de multiplexage 57, qui les distribue à la matrice de commutation 25, aux convertisseurs à démodulation directe 26 et au remodulateur MABLR 27.

C'est un avantage de la tête hyperfréquence selon l'invention de traiter les signaux retransmis par différents satellites et de les acheminer par une liaison descendante 40-860 MHz, qui n'est autre que le câble d'antenne VHF/UHF existant. Ceci est dû à la remodulation en amplitude MABLR. Cependant, la tête hyperfréquence est également utilisable avec les récepteurs équipés d'une entrée "satellite" qui reçoivent les signaux dans la bande intermédiaire satellite 950-1700 MHz. Dans ce cas, il suffit de supprimer la démodulation FM, ce qui se fait au moyen d'un interrupteur sur la liaison 46, et de sortir avant la remodulation MABLR. Mais dans ce cas la liaison descendante doit passer la bande 40-1700 MHz. Bien entendu, la programmation de la tête hyperfréquence est adaptée pour permettre de télécommander soit la démodulation d'un canal, soit la conversion en bande intermédiaire satellite.

## Revendications

1 - Système de réception de signaux TV retransmis par satellites, destiné à la transmission d'au moins un canal parmi une pluralité de canaux depuis au moins une antenne (7,10), en unité externe, vers au moins un récepteur (4,6), en unité interne, ce système étant caractérisé en ce qu'il comprend, en unité externe, une tête hyperfréquence (23) qui comporte au moins :
– un circuit de démodulation hyperfréquence (26) qui sélectionne le canal choisi et le démodule, ce circuit (26) étant piloté par une unique source hyperfréquence (39,41) programmée depuis l'unité interne (4,6)
– un circuit de remodulation (27) en amplitude à bande latérale résiduelle (MABLR), qui délivre des signaux modulés en amplitude dans la bande 40-860 MHz, de même type que les signaux VHF/UHF reçus par les antennes (1) de transmission "terrestre".

2 - Système de réception selon la revendication 1, caractérisé en ce que la tête hyperfréquence (23) comporte en outre :
– autant d'amplificateurs (24) à faible bruit qu'il y a de sorties d'antennes (7,10) de réception par satellites,
– un circuit de sélection (25,25'), qui reçoit sur ses entrées les signaux issus des amplificateurs (24), et délivre sur ses sorties les signaux de "N" canaux choisis parmi "M" reçus par les antennes (7,10)

3 - Système de réception selon la revendication 2, caractérisé en ce que le circuit de sélection est une matrice de commutation (25), programmée depuis l'unité interne (4,6) qui permet le choix d'un programme pour la démodulation simultanée de "N" canaux parmi "M", dans une utilisation individuelle.

4 - Système de réception selon la revendication 2, caractérisé en ce que le circuit de sélection est un répartiteur de puissance (25') qui assure la démodulation de tous les canaux reçus par les antennes (7,10) dans une utilisation collective.

5 - Système de réception selon la revendication 1, caractérisé en ce que le circuit de démodulation (26), dans la tête hyperfréquence, comprend :

    – un convertisseur à faible bruit, formé par un amplificateur d'entrée (31), qui fait fonction de filtre (42), un mélangeur (32) piloté par une source hyperfréquence (39 + 41), et un amplificateur de sortie (33),

    – un mélangeur intermédiaire (49) à diode ou à transistor à effet de champ, qui mélange les signaux issus de l'amplificateur de sortie (33) et de la source hyperfréquence (39),

    – un module fréquence intermédiaire, formé par un amplificateur d'entrée (50), un comparateur de phase (34) piloté par un synthétiseur (38), et un amplificateur de boucle (35)

    – une source hyperfréquence multifréquences, pilotée par un quartz (37) et programmée par un synthétiseur (38) qui permet de sélectionner un canal programmé.

6 - Système de réception selon la revendication 5, caractérisé en ce que dans le circuit de démodulation (26), la source hyperfréquence multifréquences comprend un oscillateur commandé en tension VCO (39) muni de deux diodes varactors (52,53) sur ses deux entrées :

    – un signal issu (51) du synthétiseur (38), lui-même piloté par le quartz (37), est adressé sur une première diode varactor (53)

    – un signal issu (46) de l'amplificateur de sortie (35) du module fréquence intermédiaire est adressé sur une deuxième diode varactor (52)

    – le signal de sortie de l'oscillateur (39) est adressé en parallèle à un multiplicateur de fréquence (41) du convertisseur, au mélangeur intermédiaire (49) et en boucle de contre-réaction au synthétiseur (38).

7 - Système de réception selon la revendication 6, caractérisé en ce que la liaison (46) entre la sortie du module fréquence intermédiaire et l'oscillateur (39) constitue le démodulateur FM du circuit de démodulation.

8 - Système de réception selon la revendication 7 caractérisé en ce que le signal, démodulé en fréquence (46) à la sortie (35) du module fréquence intermédiaire est adressé à un modulateur d'amplitude à bande latérale résiduelle MABLR (27).

9 - Système de réception selon la revendication 7 caractérisé en ce que, en vue de sortir des signaux en bande intermédiaire satellite (950-1700 MHz), le démodulateur FM (46) est muni d'un interrupteur (58).

10 - Système de réception selon la revendication 5 caractérisé en ce que la programmation, depuis l'unité interne, des canaux sélectionnés, se fait au moyen de signaux numériques acheminés par la liaison (3) interne/externe, et adressés au synthétiseur (38) du module fréquence intermédiaire de la tête hyperfréquence (23).

11 - Système de réception selon la revendication 1, caractérisé en ce qu'il fonctionne avec une unique liaison (3) interne/externe, qui achemine les signaux TV en liaison descendante et les signaux numériques de programmation en liaison montante, lesdits signaux numériques étant remis en forme (56) avant multiplexage (57) vers la matrice de sélection (25), les synthétiseurs (38) et la remodulation d'amplitude à bande latérale résiduelle (27).

## Patentansprüche

1.  Empfangssystem für Fernsehsignale, die von Satelliten zurückgestrahlt werden, für die Übertragung wenigstens eines Kanals unter mehreren Kanälen ausgehend von wenigstens einer Antenne (7, 10) als externe Einheit zu wenigstens einem Empfänger (4, 6) als interne Einheit, wobei dieses System dadurch gekennzeichnet ist, daß es als externe Einheit eine Mikrowellen-Vorstufe (23) enthält, die wenigstens umfaßt:

    – eine Mikrowellen-Demodulationsschaltung (26) die den gewählten Kanal auswählt und ihn demoduliert, wobei diese Schaltung (26) durch eine einzige Mikrowellen-Sonde (39, 41) angesteuert wird, die von der internen Einheit (4, 6) her programmiert wird;

    – eine Restseitenband-Amplituden-Remodulationsschaltung (27) (MABLR), die amplitudenmodulierte Signale im Band 40 - 860 MHz abgibt, von gleicher Art wie die VHF/UHF-Signale, die von den "terrestrischen" Übertragungsantennen (1) empfangen werden.

2.  Empfangssytem nach Anspruch 1, dadurch gekennzeichnet, daß die Mikrowellen-Vorstufe (23) ferner umfaßt:

    – ebensoviele rauscharme Verstärker (24) wie Satelliten-Empfangsantennenausgänge (7, 10) vorhanden sind,

    – eine Selektionsschaltung (25, 25'), die an ihren Eingängen die von den Verstärkern (24) abgegebenen Signale empfängt und an ihren Ausgängen die Signale von "N" Kanälen ausgibt, die unter "M" Kanälen ausgewählt sind, welche von den Antennen (7, 10) empfangen werden.

3. Empfangssystem nach Anspruch 2, dadurch gekennzeichnet, daß die Selektionsschaltung eine Schaltmatrix (25) ist, die von der internen Einheit (4, 6) her programmiert wird, welche die Auswahl eines Programms für die gleichzeitige Demodulation von "N" Kanälen unter "M" Kanälen in einer individuellen Anwendung ermöglicht.

4. Empfangssystem nach Anspruch 2, dadurch gekennzeichnet, daß die Selektionsschaltung ein Leistungsverteiler (25') ist, der die Demodulation aller Kanäle ermöglicht, die von den Antennen (7, 10) in einer Gemeinschaftsanlage empfangen werden.

5. Empfangssystem nach Anspruch 1, dadurch gekennzeichnet, daß die Demodulationsschaltung (26) in der Mikrowellen-Vorstufe umfaßt:
   – einen rauscharmen Konverter, der durch einen Eingangverstärker (31), der als Filter (42) arbeitet, einen Mischer (32), der durch eine Mikrowellen-Sonde (39 + 41) angesteuert wird, und einen Ausgangsverstärker (33) gebildet ist,
   – einen Zwischen-Mischer (49) mit einer Diode oder einem Feldeffekttransistor, welcher die von dem Ausgangsverstärker (33) und die von der Mikrowellen-Sonde (39) ausgehenden Signale mischt,
   – einen Zwischenfrequenz-Modul, der durch einen Eingangsverstärker (50), einen Phasenkomparator (34), der durch eine Syntheseeinrichtung (38) gesteuert wird, und einen Schleifenverstärker (35) gebildet ist,
   – eine Multifrequenz-Mikrowellen-Quelle, die durch einen Quarz (37) gesteuert wird und durch eine Syntheseeinrichtung (38) programmiert wird, welche die Auswahl eines programmierten Kanals ermöglicht.

6. Empfangssystem nach Anspruch 5, dadurch gekennzeichnet, daß in der Demodulationsschaltung (26) die Multifrequenz-Mikrowellen-Quelle einen spannungsgesteuerten Oszillator VCO (39) umfaßt, der an seinen zwei Eingängen mit zwei Varaktor-Dioden (52, 53) versehen ist:
   – ein von der Syntheseeinrichtung (38), die ihrerseits durch den Quarz (37) gesteuert wird, ausgehendes Signal (51) wird an eine erste Varaktor-Diode (53) angelegt;
   – ein von dem Ausgangsverstärker (35) des Zwischenfrequenz-Moduls ausgehendes Signal (46) wird an die zweite Varaktor-Diode (52) angelegt;

   – das Ausgangssignal des Oszillators (39) wird parallel an einen Frequenzmultiplizierer (41) des Konverters, an den Zwischen-Mischer (49) und an die Syntheseeinrichtung (38) in Gegenkopplungs-Schleife angelegt.

7. Empfangssystem nach Anspruch 6, dadurch gekennzeichnet, daß die Verbindung (46) zwischen dem Ausgang des Zwischenfrequenz-Moduls und dem Oszillator (39) den FM-Demodulator der Demodulationsschaltung bildet.

8. Empfangssystem nach Anspruch 7, dadurch gekennzeichnet, daß das am Ausgang (35) des Zwischenfrequenz-Moduls frequenzdemodulierte Signal (46) an einen Restseitenband-Amplituden-Modulator MABLR (27) angelegt ist.

9. Empfangssystem nach Anspruch 7, dadurch gekennzeichnet, daß der FM-Demodulator (46) zur Abgabe der Signale im Satelliten-Zwischenband (950 bis 1700 MHz) mit einem Unterbrecher (58) versehen ist.

10. Empfangssystem nach Anspruch 5, dadurch gekennzeichnet, daß die von der internen Einheit ausgehende Programmierung der gewählten Kanäle mittels Digitalsignalen erfolgt, die über die interne/externe Verbindung (3) geführt und an die Syntheseeinrichtung (38) des Zwischenfrequenz-Moduls der Mikrowellen-Vorstufe (23) angelegt werden.

11. Empfangssystem nach Anspruch 1, dadurch gekennzeichnet, daß es mit einer einzigen internen/externen Verbindung (3) betrieben wird, welche die Fernsehsignale nach unten und die digitalen Programmiersignale nach oben überträgt, wobei diese digitalen Signale vor der Multiplexierung (57) zu der Selektionsmatrix (25), den Syntheseeinrichtungen (38) und der Restseitenband-Amplituden-Remodulation (27) hin einer erneuten Formgebung (56) unterzogen werden.

Claims

1. System for the reception of TV signals retransmitted by satellites, intended for the transmission of at least one channel amongst a plurality of channels from at least one aerial (7, 10), in an external unit, towards at least one receiver (4, 6), in an internal unit, this system being characterised in that it comprises, in an external unit, a microwave head (23) which consists of at least:
   – a microwave demodulation circuit (26) which selects the chosen channel and demodulates it, this circuit (26) being controlled by a single microwave source (39, 41) programmed from the internal unit (4, 6)
– a vestigial sideband amplitude remodulation (VSBAM) circuit (27), which delivers amplitude modulated signals in the 40-860 MHz band, of the same type as the VHF/UHF signals received by the "terrestrial" transmitting aerials (1).

2. Reception system according to Claim 1, characterised in that the microwave head (23) consists in addition of:
– as many low-noise amplifiers (24) as there are outputs from satellite receiving aerials (7, 10).
– a selection circuit (25, 25'), which receives at its inputs the signals originating from the amplifiers (24) and delivers at its outputs the signals from "N" channels chosen amongst "M" received by the aerials (7, 10).

3. Reception system according to Claim 2, characterised in that the selection circuit is a switching matrix (25) programmed from the internal unit (4, 6) which permits the choice of a program for the simultaneous demodulation of "N" channels amongst "M", in an individual use.

4. Reception system according to Claim 2, characterised in that the selection circuit is a power divider (25') which provides for the demodulation of all the channels received by the aerials (7, 10) in a collective use.

5. Reception system according to Claim 1, characterised in that the demodulation circuit (26), in the microwave head, comprises:
– a low-noise converter, formed by an input amplifier (31), which acts as a filter (42), a mixer (32) control led by a microwave source (39 + 41), and an output amplifier (33),
– an intermediate mixer (49) with diode or field effect transistor, which mixes the signals originating from the output amplifier (33) and from the microwave source (39),
– an intermediate frequency module, formed by an input amplifier (50), a phase comparator (34) controlled by a synthesiser (38), and a loop amplifier (35),
– a multifrequency microwave source, controlled by a quartz crystal unit (37) and programmed by a synthesiser (38) which enables a programmed channel to be selected.

6. Reception system according to Claim 5, characterised in that, in the demodulation circuit (26), the multifrequency microwave source comprises a voltage controlled oscillator VCO (39) provided with two varactor diodes (52, 53) at its two inputs:
– a signal originating (51) from the synthesiser (38), itself controlled by the quartz crystal unit (37), is addressed to a first varactor diode (53),
– a signal originating (46) from the output amplifier (35) of the intermediate frequency module is addressed to a second varactor diode (52),
– the output signal from the oscillator (39) is addressed in parallel to a frequency multiplier (41) of the converter, to the intermediate mixer (49), and in a negative feedback loop to the synthesiser (38).

7. Reception system according to Claim 6, characterised in that the link (46) between the output from the intermediate frequency module and the oscillator (39) forms the FM demodulator of the demodulation circuit.

8. Reception system according to Claim 7, characterised in that the signal, frequency demodulated (46) at the output (35) of the intermediate frequency module, is addressed to a VSBAM vestigial sideband amplitude modulator (27).

9. Reception system according to Claim 7, characterised in that, with a view to outputting signals in the intermediate satellite band (950-1700 MHz), the FM demodulator (46) is provided with an on-off switch (58).

10. Reception system according to Claim 5, characterised in that the programming, from the internal unit, of the selected channels is achieved by means of digital signals routed through the internal/external link (3), and addressed to the synthesiser (38) of the intermediate frequency module of the microwave head (23).

11. Reception system according to Claim 1, characterised in that it operates with a single internal/external link (3), which routes the TV signals into the downlink and the programming digital signals into the uplink, the said digital signals being reshaped (56) before multiplexing (57) towards the selection matrix (25), the synthesisers (38) and the vestigial sideband amplitude remodulation (27).

FIG. 1

FIG. 2

FIG.3

FIG.4

FIG.5

FIG.6

FIG.7

**FIG.8**

**FIG.9**